# EUROPEAN PATENT APPLICATION

(11) **EP 4 373 222 A1**
(43) Date of publication of application: **22.05.2024**
(21) Application number: 22849263.3
(22) Date of filing: 13.07.2022
(51) Int. Cl.: H05K 1/02, H05K 3/00

(54) **BONDED SUBSTRATE, CIRCUIT BOARD AND METHOD FOR PRODUCING SAME, AND INDIVIDUAL SUBSTRATE AND METHOD FOR PRODUCING SAME**

(30) Priority: 26.07.2021 JP 2021121334
(71) Applicant: Denka Company Limited, Tokyo 103-8338 (JP)
(72) Inventor: YUASA, Akimasa, Tokyo 103-8338 (JP)
(74) Representative: Hoffmann Eitle
(86) International application number: PCT/JP2022/027589
(87) International publication number: WO 2023/008199

(57) **Abstract**

Provided is a joined substrate including: a ceramic plate including a plurality of sections defined by division lines formed on at least one of a first main surface and a second main surface; and a pair of metal plates respectively joined to the ceramic plate so as to cover the first main surface and the second main surface, in which at least one of the pair of metal plates has a plurality of first identification marks on its surface thereof. The ceramic plate includes a conductor formation region and a dummy region, and at least one of the pair of metal plates has a plurality of first identification marks on a surface of a portion covering the conductor formation region.

## Description

### Technical Field

The present disclosure relates to a joined substrate, a circuit substrate and a method for manufacturing the same, and an individual substrate and a method for manufacturing the same.

### Background Art

An insulating ceramic substrate may be used for an individual substrate to be mounted on electronic devices. As a multi-piece wiring substrate for obtaining such an individual substrate, there is known one in which a plurality of wiring substrate regions are arranged vertically and horizontally, a dummy region is provided in an outer peripheral portion, and a symbol pattern consisting of a void is provided in an inner layer of each wiring substrate region (for example, Patent Document 1). If such a symbol pattern is analyzed using an ultrasonic flaw detector, an X-ray, or the like, the arrangement position of the wiring substrate region can be detected.

In addition, there is known a manufacturing method including a step of drawing a barcode or a two-dimensional code by irradiating a part of a ceramic green sheet used as a material of an individual substrate with laser beam, a step of obtaining a ceramic substrate including a plurality of substrate formation regions by firing the ceramic green sheet, and a step of dividing the ceramic substrate (for example, Patent Documents 2 and 3). Accordingly, the molding lot number can be associated with the final product.

### Citation List

### Patent Literature

[Patent Document 1] Japanese Unexamined Patent Publication No. 2005-210028
[Patent Document 2] PCT International Publication No. WO2020/179699
[Patent Document 3] PCT International Publication No. WO2021/020471

### Summary of Invention

### Technical Problem

Identification marks such as symbol patterns and two-dimensional codes described in Patent Documents 1 to 3 are considered to be useful for achieving traceability. Accordingly, the present disclosure provides a circuit substrate and a method for manufacturing the same that are excellent in traceability. Further, provided is a joined substrate excellent in traceability. Yet further, provided is an individual substrate and a method for manufacturing the same that are excellent in traceability.

### Solution to Problem

The present disclosure provides in some aspects the following [1] to [11].
[1] Ajoined substrate comprising:
   a ceramic plate including a plurality of sections defined by a division line formed on at least one of a first main surface and a second main surface; and
   a pair of metal plates joined to the ceramic plate to cover the first main surface and the second main surface, respectively,
   wherein at least one of the pair of metal plates has a plurality of first identification marks on a surface thereof.
[2] The joined substrate according to [1], wherein the ceramic plate includes a conductor formation region and a dummy region, and
   wherein at least one of the pair of metal plates has the plurality of first identification marks on a surface of a portion covering the conductor formation region.
[3] The joined substrate according to [1] or [2], wherein the plurality of first identification marks include a code formed of a laser hole, and the laser hole has a depth of 3 µm or more.
[4] The joined substrate according to any one of [1] to [3], wherein the pair of metal plates include a protruding portion protruding outward from the first main surface and the second main surface of the ceramic plate, and the plurality of first identification marks are provided on an inner side of the protruding portion, and
   wherein a corner portion of the ceramic plate protrudes outward from the pair of metal plates.
[5] A circuit substrate comprising: a ceramic plate including a plurality of sections defined by a division line formed on at least one of a first main surface and a second main surface; a plurality of first conductor portions provided independently for each section on the first main surface; and
   a plurality of second conductor portions provided independently for each section on the second main surface,
   wherein each of the plurality of first conductor portions has a second identification mark on a surface thereof.
[6] A circuit substrate obtained by performing at least an etching process on the joined substrate according to any one of [1] to [4], the circuit substrate comprising:
   a plurality of first conductor portions provided independently for each section on the first main surface; and
   a plurality of second conductor portions provided independently for each section on the second main surface,
   wherein each of the plurality of first conductor portions has a second identification mark derived from one of the plurality of first identification marks on a surface thereof.
[7] The circuit substrate according to [5] or [6], wherein the second identification mark includes a code formed of a laser hole, and the laser hole has a depth of 1 µm or more.
[8] An individual substrate obtained by dividing the circuit substrate according to any one of [5] to [7] along the division line, the individual substrate comprising:
   one of the plurality of sections; one of the plurality of first conductor portions; and one of the plurality of second conductor portions, wherein one of the plurality of first conductor portions has the second identification mark on a surface thereof.
[9] The individual substrate according to [8], wherein one of the first conductor portions constitutes a heat dissipation portion, and one of the second conductor portions constitutes an electric circuit.
[10] A method for manufacturing a circuit substrate, the method comprising:
   performing at least an etching process on the joined substrate according to any one of [1] to [4] to form a plurality of first conductor portions on the first main surface so as to be independent for each section, and to form a plurality of second conductor portions on the second main surface so as to be independent for each section,
   wherein each of the plurality of first conductor portions has a second identification mark derived from one of the first identification marks on a surface thereof.
[11] A method for manufacturing an individual substrate, the method comprising:
   performing at least an etching process on the joined substrate according to any one of [1] to [4] to form a plurality of first conductor portions on the first main surface so as to be independent for each section, and to form a plurality of second conductor portions on the second main surface so as to be independent for each section; and
   dividing a circuit substrate comprising the plurality of first conductor portions and the plurality of second conductor portions along the division line to obtain an individual substrate comprising one of the plurality of sections, one of the plurality of first conductor portions and one of the plurality of second conductor portions, wherein one of the plurality of first conductor portions has a second identification mark on a surface thereof, the second identification mark being derived from one of the first identification marks.

In the joined substrate according to [1], at least one of the pair of metal plates has a plurality of first identification marks on the surface thereof. The plurality of first identification marks can improve reading accuracy as compared with a case where the identification mark is provided inside the joined substrate. Accordingly, the traceability is excellent.

The joined substrate may have a configuration according to [2]. Accordingly, a multi-piece circuit substrate is formed from the joined substrate, and an identification mark can be provided for each individual substrate obtained by singulating the circuit substrate. Therefore, the range of traceability can be expanded to the individual substrate.

The joined substrate may have a configuration according to [3]. Accordingly, even after the joined substrate is subjected to surface finishing and etching, the reading accuracy of an identification mark derived from the first identification mark can be sufficiently maintained. Thus, the reliability of the traceability can be sufficiently enhanced.

The joined substrate may have a configuration according to [4]. Since the pair of metal plates includes a protruding portion and the plurality of first identification marks are provided inward from the protruding portion, it is possible to prevent the brazing material joining the metal plates and the ceramic plate from oozing out to the surface of the metal plate and covering the first identification marks. Accordingly, the reading accuracy of the first identification mark can be maintained sufficiently high. In addition, since the corner portion of the ceramic plate is exposed, the alignment can be performed using the corner portion. Such a joined substrate, and a circuit substrate and an individual substrate obtained therefrom are excellent in dimensional accuracy.

In the circuit substrate according to [5] described above, each of the plurality of first conductor portions has a second identification mark on the surface thereof. Such a circuit substrate can improve the reading accuracy as compared with a case where the identification mark is provided therein. Accordingly, the traceability is excellent. In addition, it is possible to manage the circuit substrate associatively from obtaining a circuit substrate to dividing the circuit substrate into a plurality of sections. In this way, the range of traceability can be expanded.

In the circuit substrate according to [6] described above, each of the first conductor portions has a second identification mark on the surface thereof. Such a circuit substrate can increase the reading accuracy as compared with a case where an identification mark is provided therein. Accordingly, the traceability is excellent. In addition, it is possible to manage the circuit substrate associatively from obtaining a circuit substrate to dividing the circuit substrate into a plurality of sections after. Further, the second identification mark is derived from one of the first identification marks. Accordingly, it is possible to ensure excellent traceability in the entire process until obtaining the divided substrate (individual substrate) from the joined substrate.

The circuit substrate may have a configuration according to [7]. Accordingly, the reading accuracy can be sufficiently maintained. Therefore, the reliability of the traceability can be sufficiently enhanced.

The individual substrate according to [8] described above has a second identification mark on the surface of the first conductor portion. Such a second identification mark can improve reading accuracy as compared with a case where the identification mark is provided inside the individual substrate. Accordingly, the individual substrate is highly traceable. In addition, since the individual substrate is obtained by dividing any one of the circuit substrates described above along the division line, traceability from the circuit substrate to the individual substrate can be ensured.

The individual substrate may have a configuration according to [9]. In the individual substrate, the first conductor portion constituting a heat dissipation portion has a second identification mark. Accordingly, it is possible to improve connection reliability by sufficiently flattening the surface of the second conductor portion constituting the electric circuit while having excellent traceability.

In the method for manufacturing a circuit substrate according to [10] described above, since the joined substrate has the first identification mark on the surface of the metal plate and the circuit substrate has the second identification mark derived from the first identification mark on the surface of each of the plurality of first conductor portions, traceability from the joined substrate to the circuit substrate can be ensured. In addition, the first identification mark and the second identification mark are excellent in reading accuracy since the first identification mark and the second identification mark are provided on the surface of the metal plate and the first conductor portion. Accordingly, the method for manufacturing the circuit substrate is excellent in traceability.

In the method for manufacturing the individual substrate according to [11] described above, since the joined substrate has the first identification mark on the surface of the metal plate and the individual substrate has the second identification mark derived from the first identification mark on the surface of the first conductor portion, traceability from the joined substrate to the individual substrate can be ensured. In addition, the first identification mark and the second identification mark are excellent in reading accuracy. Accordingly, the method for manufacturing the individual substrate is excellent in traceability.

### Advantageous Effects of Invention

A joined substrate excellent in traceability can be provided. Further, a circuit substrate and a method for manufacturing the same that are excellent in traceability can be provided. Yet further, an individual substrate and a method for manufacturing the same that are excellent in traceability can be provided.

### Brief Description of Drawings

FIG. 1 is a perspective view of a joined substrate according to one embodiment.
FIG. 2 is a plan view of the joined substrate according to one embodiment.
FIG. 3 is a diagram illustrating an example of an identification mark of the joined substrate of FIGS. 1 and 2.
FIG. 4 is a cross-sectional view taken along line IV-IV of the circuit substrate of FIG. 1.
FIG. 5 is a plan view of a ceramic plate.
FIG. 6 is a diagram illustrating one surface of the circuit substrate according to one embodiment.
FIG. 7 is a diagram illustrating another surface of the circuit substrate according to an embodiment.
FIG. 8 is a perspective view of an individual substrate according to one embodiment.
FIG. 9 is a cross-sectional view illustrating an example of a power module.

### Description of Embodiments

Hereinafter, embodiments of the present disclosure will be described with reference to the drawings as the case may be. However, the following embodiments are examples for describing the present disclosure and are not intended to limit the present disclosure to the following contents. In the description, the same reference numerals are used for the same elements or elements identical in terms of function with redundant description omitted as the case may be. In addition, positional relationships including up, down, left, and right are based on positional relationships illustrated in the drawings unless otherwise noted. The dimensional ratio of each element is not limited to the illustrated ratio. The upper limit or the lower limit of the numerical range specified in the present specification may be replaced by any value shown in the examples. In addition, the upper limit value and the lower limit value described individually may be arbitrarily combined.

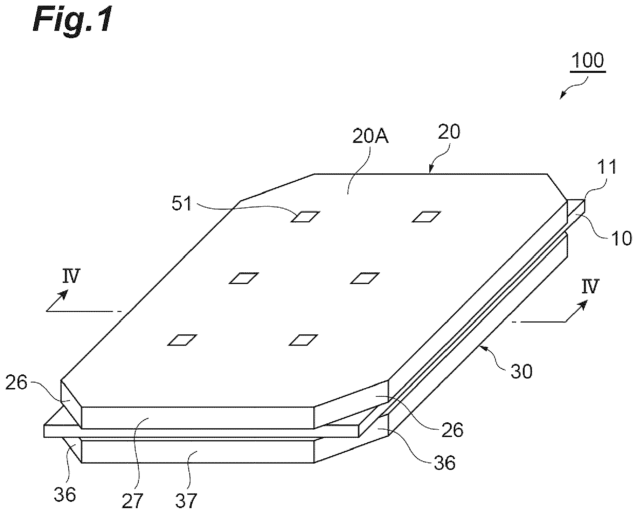

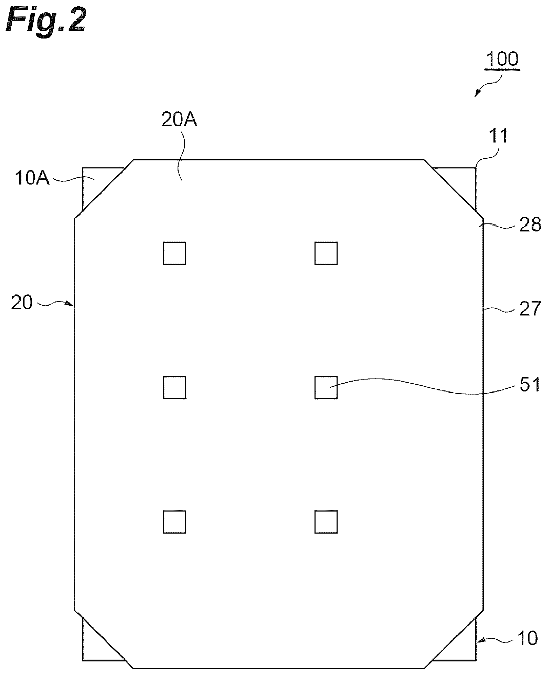

FIG. 1 is a perspective view of a joined substrate 100, and FIG. 2 is a plan view of the joined substrate 100. The joined substrate 100 includes: a ceramic plate 10; and a pair of metal plates 20 and 30 joined to the ceramic plate 10 so as to cover a first main surface 10A and a second main surface of the ceramic plate 10, respectively. The pair of the metal plates 20 and 30 may be, for example, a copper plate or an aluminum plate. The joined substrate 100 has a first identification mark 51 on a surface 20A of a metal plate 20. The surface of a metal plate 30 may or may not have a similar identification mark. The surface 20A is provided with the same number of first identification marks 51 as the number of sections included in the conductor formation region of the ceramic plate 10.

The first identification mark 51 may be any mark that allows identifying the metal plate 20 and the joined substrate 100. For example, the first identification mark 51 may be a one-dimensional code such as a barcode or may be a two-dimensional code. The first identification mark 51 may be printed on the surface 20A, or may be formed in a rugged shape. For example, the first identification mark 51 may be a combination of a recessed portion and a pattern. The plurality of first identification marks 51 may be the same as or different from each other. If the plurality of first identification marks 51 are different from each other, it is possible to ensure traceability after singulation.

The first identification mark 51 is configured to be detected by an imaging device such as a camera or video, for example. The imaging device may include, for example, an information processing unit that collates a captured image with information recorded in advance and outputs information based on the collation result. The same applies to other identification marks in the present disclosure.

The first identification mark 51 may be used to identify the joined substrate 100 and a circuit substrate 200 described below. If the first identification mark 51 is provided on the surface of the metal plate 20 (30) before the joined substrate 100 is manufactured, the metal plate 20 (30) can be identified. The first identification mark 51 may be a code associated with some information. The information may relate to, for example, a lot, manufacturing history, product type, application, quality, and manufacturing conditions. By using the first identification mark 51, the traceability of the metal plates 20 and 30, the joined substrate 100 and various products obtained therefrom can be improved. For example, the first identification mark 51 may be used to provide quality control and process control.

The first identification mark 51 may be, for example, one in which one or two or more of the following pieces of information (a), (b), (c), (d), (e), and (f) are encoded.
(a) Information about the metal plate
(b) Manufacturing information of the joined substrate (manufactured date, manufacturing condition, manufacturing facility, and the like)
(c) Quality information of the joined substrate
(d) Surface finishing conditions of the joined substrate
(e) Etching conditions of the joined substrate
(f) Serial number of the joined substrate

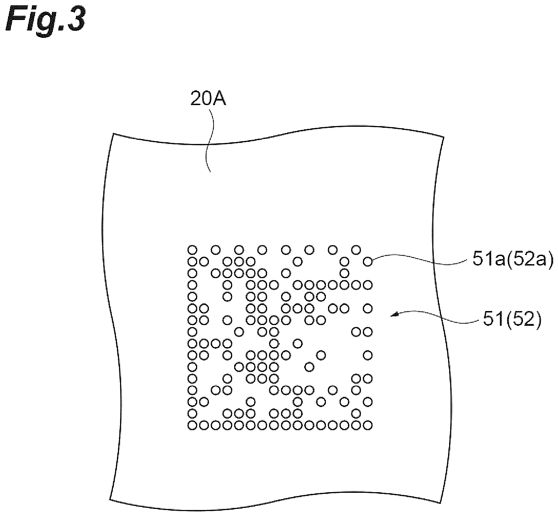

FIG. 3 is a diagram illustrating an example of the first identification mark 51. The first identification mark 51 is a two-dimensional code and formed of a plurality of recessed portions 5 1a arranged in accordance with a predetermined rule. The first identification mark 51 may be, for example, a two-dimensional barcode such as QR code (registered trademark). In addition, the first identification mark 51 may be a three-dimensional code using, for example, information related to the depth of the recessed portions 51a. The recessed portions 51a may be laser holes formed by a laser beam. As the laser source, for example, a carbon dioxide gas laser, a YAG laser or the like can be used. The first identification mark 51 is not limited to one formed of the recessed portions 51a.

The depth of the recessed portion 51a constituting the first identification mark 51 may be 3 µm or more, or may be 5 µm or more. Accordingly, sufficient reading accuracy can be ensured even after surface treatment such as chemical polishing is performed. The depth of the recessed portion 51a may be 50 µm or less, 30 µm or less, or less than 10 µm. By reducing the depth in this manner, it is possible to shorten the time for forming the laser hole and to reduce the amount of foreign matter (dross) generated due to the formation of the laser hole.

The code size of the first identification mark 51 may be 1 to 4 mm on each side in a plan view. Accordingly, it is possible to sufficiently increase connection reliability after singulation while sufficiently maintaining detection accuracy of the imaging device. From the viewpoint of ensuring a quantity of information while having such a size, the number of cells (the maximum number of the recessed portions 51a arranged along one direction) may be 5 to 30, or may be 10 to 20.

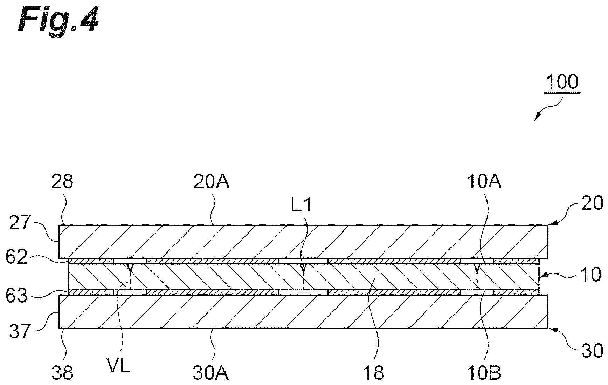

As illustrated in the cross-sectional view of FIG. 4, the metal plate 20 and the metal plate 30 are joined to the first main surface 10A and a second main surface 10B of the ceramic plate 10 via a brazing layer 62 and a brazing layer 63, respectively. An outer edge 27 of the metal plate 20 and an outer edge 37 of the metal plate 30 protrude outward from the first main surface 10A and the second main surface 10B of the ceramic plate 10. Since the metal plate 20 and the metal plate 30 have such a protruding portion 28 and a protruding portion 38, respectively, it is possible to prevent oozing of the brazing material components onto the surface 20A of the metal plate 20 and a surface 30A of the metal plate 30.

The first identification mark 51 is provided inward from the protruding portion 28. Accordingly, it is possible to sufficiently prevent the first identification mark 51 from being covered with the brazing material components. Such a first identification mark 51 is excellent in reading accuracy. If an identification mark is provided on the surface 30A of the metal plate 30, the identification mark may be provided on the inner side of the protruding portion 38. The surface 30A of the metal plate 30 does not need to have the identification mark.

In FIG. 4, the brazing layers 62 and 63 are provided only at a portion corresponding to a portion to be a conductor portion when the circuit substrate is manufactured. That is, there is a gap between adjacent brazing layers. In some modifications, such a gap does not need to be provided. That is, the brazing layer may be formed by coating the first main surface 10A and the second main surface 10B with a brazing material. The ceramic plate 10 is configured to be dividable along a virtual dividing line VL starting from a division line L1 (a division line L2). Sections 18 are three-dimensional regions defined by the division line L1 (the division line L2) and the virtual dividing line VL.

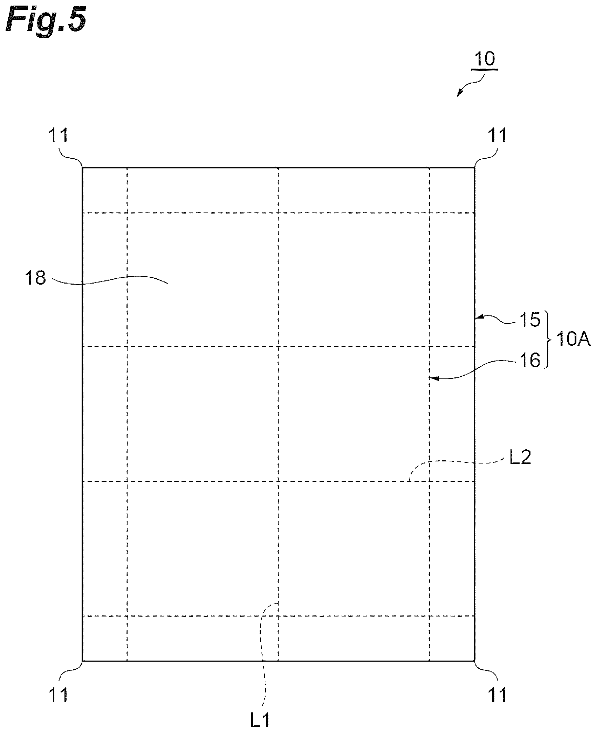

As illustrated in FIG. 5, the first main surface 10A of the ceramic plate 10 is rectangular and a plurality of sections 18 are defined by division lines L1 and L2. On the first main surface 10A, a plurality of division lines L1 extending along a first direction and arranged at equal intervals and a plurality of division lines L2 extending along a second direction perpendicular to the first direction and arranged at equal intervals are provided as division lines. The division lines L1 and the division lines L2 are perpendicular to each other.

For example, the division lines L1 and L2 may be configured such that a plurality of recesses are linearly arranged, or a groove may be linearly formed. Specifically, the division lines L1 and L2 may be a scribe line formed by laser beam. Examples of the laser source include a carbon dioxide gas laser and a YAG laser. The scribe line can be formed by intermittently irradiating a laser beam from such a laser source. The division lines L1 and L2 do not need to be arranged at equal intervals, and are not limited to being perpendicular to each other. The division lines L1 and L2 may be curved or bent instead of a straight line. In FIG. 5, the division lines L1 and L2 are provided only on the first main surface 10A of the ceramic plate 10, but the division lines L1 and L2 may also be formed on the other main surface (the second main surface 10B) of the ceramic plate 10.

As illustrated in FIG. 5, the ceramic plate 10 has: a conductor formation region 16 including six sections 18 defined by two division lines L1 positioned outermost and two division lines L2 positioned outermost; and a dummy region 15 surrounding the conductor formation region 16. Each of the six the sections 18 defined by the division lines L1 and L2 in the conductor formation region 16 may be formed with a conductor portion constituting an electric circuit or a heat dissipation portion.

The first identification marks 51 on the joined substrate 100 of FIGS. 1 and 2 are provided on the surface 20A of the portion of the metal plate 20 that covers the conductor formation region 16 of the ceramic plate 10. The first identification marks 51 are provided on the surfaces 20A in portions of the metal plate 20 that cover each of the plurality of the section 18. That is, one first identification mark 51 is provided on the surface 20A for each the section 18. If a plurality of the first identification marks 51 are different from each other, the range of traceability can be expanded to the individual substrates after division.

As illustrated in FIGS. 1, 2, and 5, in the joined substrate 100, corner portions 11 of the ceramic plate 10 protrude outward from the pair of the metal plates 20 and 30. Four corners of each of the pair of the metal plates 20 and 30 are chamfered. The corner portions 11 of the ceramic plate 10 are exposed between chamfered portions 26 and 36 of the pair of the metal plates 20 and 30. The shapes of the chamfered portions 26 and 36 are not particularly limited, and may be, for example, a C-chamfered shape or an R-chamfered shape. The shapes of the pair of the metal plates 20 and 30 may be the same or may be different.

The position of the corner portion 11 of the ceramic plate 10 can be easily detected when the joined substrate 100 is viewed in plan view as illustrated in FIG. 2. Accordingly, by using the corner portions 11 as a reference for positioning the joined substrate 100, the joined substrate 100 can be processed smoothly and with high accuracy. As a result, a processed product excellent in dimensional accuracy can be smoothly manufactured.

In some modifications, the first identification mark 51 on the surface 20A of the metal plate 20 may disappear by subjecting the joined substrate 100 to a surface treatment or the like. Accordingly, it is possible to obtain a circuit substrate and an individual substrate in which the identification mark does not remain while ensuring the traceability of the joined substrate 100. If the first identification mark 51 is composed of the recessed portion 51a, the depth of the recessed portion 51a may be less than 1 µm, for example. The first identification mark 51 may be a two-dimensional mark drawn by printing or the like.

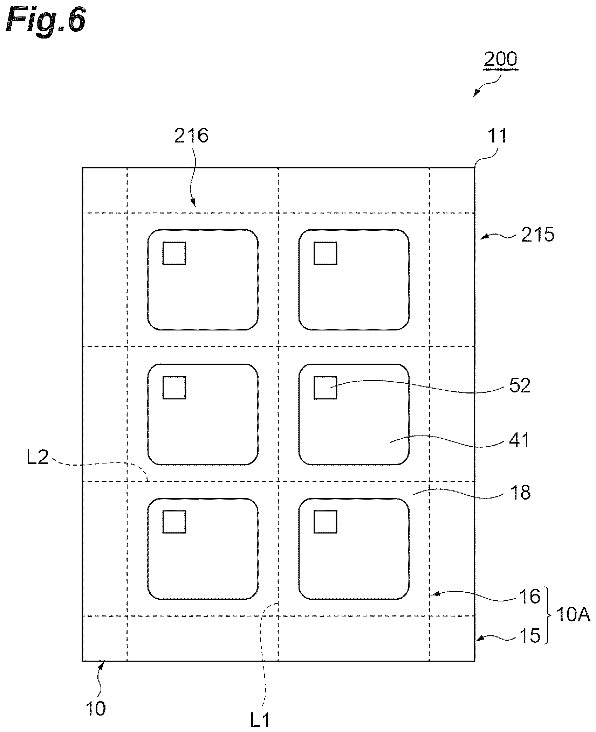

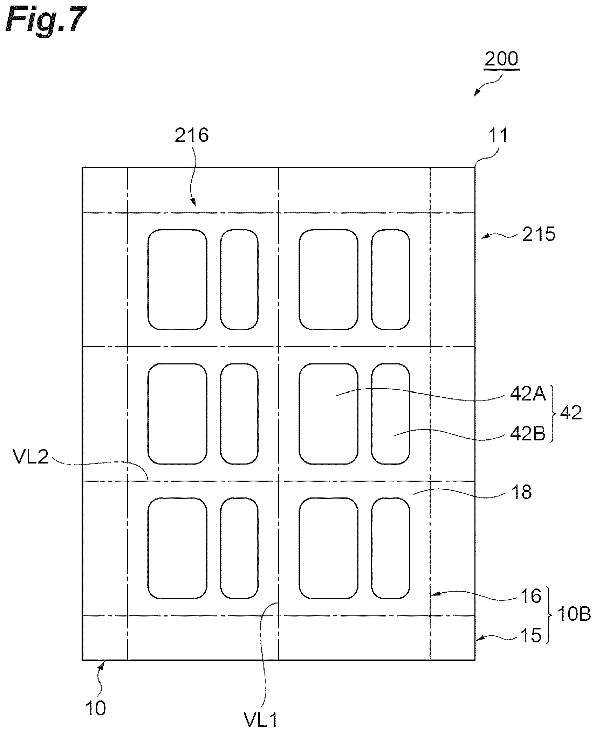

FIG. 6 is a plan view illustrating one surface side (the first main surface 10A side) of the circuit substrate 200, and FIG. 7 is a plan view showing one surface side (the second main surface 10B side) of the circuit substrate 200. The circuit substrate 200 illustrated in FIGS. 6 and 7 includes: the ceramic plate 10 including a plurality of sections 18 defined by the division lines L1 and L2 formed on the first main surface 10A; a plurality of first conductor portions 41 provided independently for each section 18 on the first main surface 10A of the ceramic plate 10; and a plurality of second conductor portions 42 provided independently for each section 18 on the second main surface 10B of the ceramic plate 10. Each of the plurality of first conductor portions 41 has a second identification mark 52 on a surface thereof.

In FIG. 7, virtual division lines VL1 and VL2 are drawn on the second main surface 10B of the ceramic plate 10. The virtual division lines VL1 and VL2 are virtual lines drawn on the second main surface 10B based on the virtual dividing lines VL in FIG. 4. That is, the virtual division lines VL1 and VL2 correspond to those obtained by transferring the planar shape of the division lines L1 and L2 on the first main surface 10A to the second main surface 10B. The virtual division lines VL1 and VL2 define the sections 18 together with the virtual dividing line VL and the division lines L1 and L2. Although the virtual division lines VL1 and VL2 are drawn on the second main surface 10B in FIG. 7, the second main surface 10B may also have the division lines L1 and L2 similar to the first main surface 10A in some modifications. In some other modifications, the sections 18 in the conductor formation region 16 may be defined by providing the division lines L1 and L2 on the second main surface 10B and drawing virtual division lines VL1 and VL2 on the first main surface 10A.

The circuit substrate 200 includes: a conductor formation portion 216 having a plurality of first conductor portions 41 and a plurality of second conductor portions 42 on the first main surface 10A and the second main surface 10B, respectively; and a dummy portion 215 surrounding the conductor formation portion 216. The conductor formation portion 216 includes a plurality of sections 18.

From the circuit substrate 200 illustrated in FIGS. 6 and 7, a plurality of (six pieces) individual substrates are obtained by dividing the ceramic plate 10 along the division lines L1 and L2. At this time, the ceramic plate 10 is cut at the virtual dividing line VL illustrated in FIG. 4. The circuit substrate 200 are also referred to as a multi-piece circuit substrate. The circuit substrate 200 may be obtained by processing the joined substrate 100 of FIG. 1. The circuit substrate 200 includes: the conductor formation portion 216 including the conductor formation region 16 of the ceramic plate 10; and the dummy portion 215 including the dummy region 15 of the ceramic plate 10. The conductor formation portion 216 includes six first conductor portions 41 and six second conductor portions 42 on the first main surface 10A and the second main surface 10B, respectively.

If the circuit substrate 200 is obtained by subjecting the joined substrate 100 to at least an etching treatment, the second identification mark 52 on the surface of the first conductor portion 41 may be derived from the first identification mark 51 of FIG. 1. That is, the first identification mark 51 and the second identification mark 52 may be exactly the same, or may be discolored or deformed by a working process for obtaining the circuit substrate 200 from the joined substrate 100. The shape and function of the first identification mark 51 and the second identification mark 52 may be the same.

The second identification mark 52 may be any mark as long as the circuit substrate 200 can be identified. For example, the second identification mark 52 may be a one-dimensional code such as a barcode or may be a two-dimensional code. The second identification mark 52 may be printed on the surface of the first conductor portion 41, or may be formed in a rugged shape. For example, a recessed portion and a pattern may be combined. The plurality of second identification marks 52 may be the same as or different from each other. If the plurality of second identification marks 52 are different from each other, it is possible to ensure the traceability of the divided individual substrates.

The second identification mark 52 may be a code associated with some information. The information may relate to, for example, a lot, manufacturing history, product type, application, quality, and manufacturing conditions. By using the second identification mark 52, the traceability of the circuit substrate 200 can be improved. The second identification mark 52 may be used for quality control and process control.

The second identification mark 52 may be, for example, one in which one or two or more of the following pieces of information (a), (b), (c), and (d) are coded.
(a) Information of the joined substrate used (information of the metal plate)
(b) Manufacturing information of the circuit substrate (manufactured date, manufacturing condition, manufacturing facility, and the like)
(c) Quality information of the circuit substrate
(d) Division condition of the circuit substrate

The second identification mark 52 of the circuit substrate 200 is easy and accurate to read because the second identification mark 52 is provided on the surface of the first conductor portion 41, reading is easy and accurate. The code size and the number of cells of the second identification mark 52 may be the same as those of the first identification mark 51. If the second identification mark 52 is formed of a recessed portion 52a illustrated in FIG. 3, the depth of the recessed portion 52a may be 1 µm or more, or may be 3 µm or more. The depth of the recessed portion 52a constituting the second identification mark 52 may be smaller than the depth of the recessed portion 51a constituting the first identification mark 51. This is because the circuit substrate 200 is not be subjected to surface treatment such as the joined substrate 100 in some cases. The depth of the recessed portion 52a of the second identification mark 52 may be 50 µm or less, 30 µm or less, or less than 10 µm from the same viewpoint as that of the recessed portion 51a.

The second conductor portion 42 illustrated in FIG. 7 includes a first circuit portion 42A and a second circuit portion 42B. A semiconductor device or the like may be mounted on at least one of the first circuit portion 42A and the second circuit portion 42B. Since the second conductor portion 42 does not have an identification mark on the surface thereof, the second conductor portion 42 can have higher shape accuracy than the first conductor portion 41. The second conductor portion 42 (the first circuit portion 42A and the second circuit portion 42B) has high connection reliability when an electric circuit is configured. The shapes of the first conductor portion 41 and the second conductor portion 42 are not limited to those illustrated in the drawings. The plurality of first conductor portions 41 may have the same shape as each other or may have different shapes from each other. The plurality of second conductor portions 42 may have the same shape as each other or may have different shapes from each other. Although the circuit substrate 200 includes the dummy portion 215, in some modifications the circuit substrate 200 does not need to have the dummy portion 215. The dummy portion 215 (the dummy region 15) is provided around the conductor formation portion 216 (the conductor formation region 16), but is not limited to such a positional relationship.

The circuit substrate 200 is divided along the division lines L1 and L2 of the ceramic plate 10, and the conductor formation portion 216 and the dummy portion 215 are separated. The conductor formation portion 216 is divided into a unit of the sections 18, resulting in six individual substrates. The individual substrate is used as a component of, for example, a power module. Since the corner portions 11 of the ceramic plate 10 are exposed in the circuit substrate 200, for example, it is possible to improve alignment accuracy when the individual substrates are obtained by dividing. Although six pieces of individual substrates can be obtained from the circuit substrate 200, the number is not particularly limited.

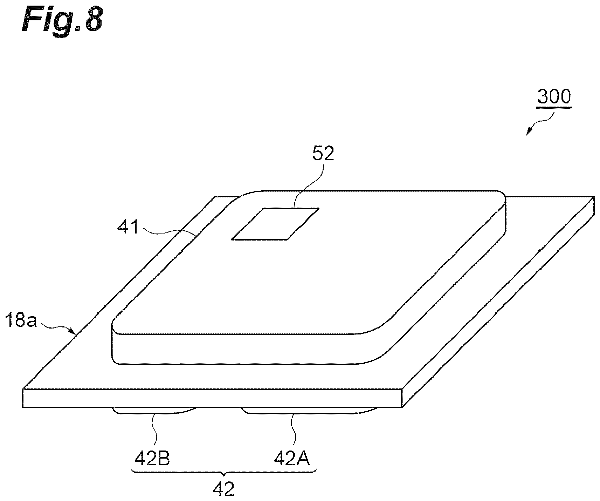

An individual substrate 300 illustrated in FIG. 8 may be obtained by dividing the circuit substrate 200 along the division lines L1 and L2, for example. The individual substrate 300 includes a divided plate 18a (ceramic plate) derived from the section 18 of the ceramic plate 10, and the first conductor portion 41 and the second conductor portion 42 so as to sandwich the divided plate 18a. The individual substrate 300 has the second identification mark 52 on the surface of the first conductor portion 41. Since the second identification mark 52 is provided on the surface of the first conductor portion 41, it is possible to increase reading accuracy compared to a case where an identification mark is provided inside the individual substrate. Accordingly, the individual substrate 300 is highly traceable.

The second identification mark 52 in the individual substrate 300 is provided only on the surface of the first conductor portion 41. In some modifications, the second identification mark 52 may be provided on the surface of the second conductor portion 42 and the second identification mark 52 may be provided on the surface of each of the first conductor portion 41 and the second conductor portion 42. In these cases, the second identification mark on the surface of the second conductor portion 42 may be exposed to the outside even after an electronic component such as a semiconductor device is mounted on the second conductor portion 42. Accordingly, it is possible to secure traceability after the electronic component is mounted. Examples of the individual substrate 300 include one in which the ceramic plate 18a is made of aluminum nitride or silicon nitride and the first conductor portion 41 and the second conductor portion 42 are made of copper or aluminum.

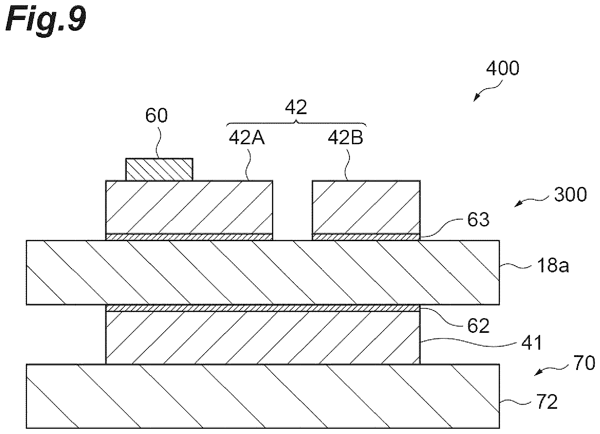

FIG. 9 is a cross-sectional view of a power module 400. The power module 400 includes the individual substrate 300, a cooling portion 72 connected to the first conductor portion 41, and a semiconductor device 60 connected to the first circuit portion 42A of the second conductor portion 42. In the individual substrate 300, the first conductor portion 41 and the ceramic plate 18a are joined via the brazing layer 62, and the second conductor portion 42 and the ceramic plate 18a are joined via the brazing layer 63. The cooling portion 72 and the first conductor portion 41 may be connected by, for example, solder. In this case, the second identification mark 52 on the surface of the first conductor portion 41 may be covered by solder or the cooling portion 72. The second conductor portion 42 constitutes an electric circuit together with the semiconductor device 60, and the first conductor portion 41 constitutes a heat dissipation portion 70 together with the cooling portion 72.

The first circuit portion 42A and the semiconductor device 60 may be connected by solder that is not illustrated. An identification mark does not need to be formed at a portion connected to the semiconductor device 60 of the first circuit portion 42A. Accordingly, the connection reliability between the first circuit portion 42A and the semiconductor device 60 can be improved. Even if a second identification mark is formed on the surface of the first conductor portion 41, the first conductor portion 41 and the cooling portion 72 can be sufficiently firmly connected by sufficiently using the solder.

An example of a method for manufacturing the joined substrate 100 will be described. First, the ceramic plate 10 is prepared. The method for manufacturing the ceramic plate 10 includes a step of irradiating a main surface of a ceramic base material with a laser beam to form the division lines L1 and L2 that partitions the main surface into a plurality of sections, thereby obtaining the ceramic plate 10 including a plurality of the sections 18 as illustrated in FIG. 5. The division lines L1 and L2 become cutting lines when the circuit substrate is divided in a subsequent process. The division lines L1 and L2 may be scribe lines. The scribe line may be formed by irradiating the surface of the ceramic base material with, for example, a carbon dioxide laser, a YAG laser, or the like.

The ceramic substrate can be obtained by firing a green sheet. The green sheet can be obtained by molding a slurry containing, for example, an inorganic compound powder, a binder resin, a sintering aid, a plasticizer, a dispersant, and a solvent. Examples of the inorganic compound include silicon nitride (Si₃N₄), aluminum nitride (AIN), silicon carbide, and aluminum oxide. Examples of the sintering aid include rare earth metals, alkaline earth metals, metal oxides, fluorides, chlorides, nitrates, and sulfates. These may be used alone or in combination of two or more kinds thereof. By using the sintering aid, sintering of the inorganic compound powder can be promoted. Examples of the binder resin include methyl cellulose, ethyl cellulose, polyvinyl alcohol, polyvinyl butyral, and (meth)acrylic resins.

Examples of the plasticizer include phthalic acid plasticizers such as purified glycerin, glycerin trioleate, diethylene glycol, and di-n-butyl phthalate; and dibasic acid plasticizers such as di-2-ethylhexyl sebacate. Examples of dispersing agents include poly (meth)acrylates and (meth)acrylic acid-maleate copolymers. Examples of the solvent include organic solvents such as ethanol and toluene.

Next, the green sheet is degreased and sintered to obtain a ceramic substrate. The degreasing may be performed, for example, by heating at 400 to 800°C for 0.5 to 20 hours. Accordingly, it is possible to reduce the residual amount of organic matter (carbon) while preventing oxidation and deterioration of the inorganic compound. The sintering is performed by heating to 1700 to 1900°C in a non-oxidizing gas atmosphere such as nitrogen, argon, ammonia, or hydrogen. By processing the ceramic substrate thus obtained, the ceramic plate 10 as illustrated in FIG. 5 is obtained.

Next, the metal plate 20 and the metal plate 30 are joined to the first main surface 10A and the second main surface 10B of the ceramic plate 10 so as to cover the first main surface 10A and the second main surface 10B, respectively, to obtain the joined substrate 100. The metal plate 20 and the metal plate 30 are joined to the first main surface 10A and the second main surface 10B of the ceramic plate 10, respectively, via brazing material.

Specifically, first, a paste-like brazing material is applied to the first main surface 10A and the second main surface 10B of the ceramic plate 10 by a method such as a roll coater method, a screen-printing method, or a transfer method. The brazing material contains, for example, a metal component such as silver or titanium, an organic solvent, and a binder. The viscosity of the brazing material may be, for example, 5 to 20Pa·s. The content of the organic solvent in the brazing material may be, for example, 5 to 25% by mass, and the content of the binder may be, for example, 2 to 15% by mass.

The metal plate 20 may have the first identification mark 51 on the surface 20A before being joined to the ceramic plate 10. Accordingly, the traceability of the metal plate 20 before joining can be ensured. The metal plate 30 may or may not have the same identification mark as that of the metal plate 20.

The metal plate 20 and the metal plate 30 are respectively stuck to the first main surface 10A and the second main surface 10B of the ceramic plate 10 to which the brazing material is applied. Thereafter, the ceramic plate 10 and the metal plates 20 and 30 are sufficiently joined by heating in a heating furnace to obtain the joined substrate 100. The heating temperature may be, for example, 700 to 900°C. The atmosphere in the furnace may be an inert gas such as nitrogen, and the heating may be performed under reduced pressure lower than atmospheric pressure, or under vacuum. The heating furnace may be of a continuous type in which a plurality of joined bodies are continuously manufactured, or may be of a type in which one or more joined bodies are batch-manufactured. The heating may be performed while pressing the joined body in the laminating direction.

In this example, the first identification mark 51 is provided on the surface 20A of the metal plate 20 before the ceramic plate 10 and the metal plates 20 and 30 are joined, but the sequence is not limited thereto. In some modifications, the first identification mark 51 may be provided on the surface 20A of the metal plate 20 after the ceramic plate 10 and the metal plates 20 and 30 are joined. Accordingly, even when the brazing material oozes out to the surface 20A of the metal plate 20 at the time of joining, the reading accuracy of the first identification mark 51 can be sufficiently increased.

A method for manufacturing a circuit substrate according to an embodiment includes a step of performing at least an etching process on a joined substrate to form a plurality of first conductor portions on a first main surface of a ceramic substrate so as to be independent for each section and to form a plurality of second conductor portions on a second main surface of the ceramic plate so as to be independent for each section. In this method for manufacturing, a joined plate including a ceramic plate having a first main surface and a second main surface and a pair of metal plate joined to the ceramic substrate so as to cover the first main surface and the second main surface may be used. Examples of such a joined substrate includes the joined substrate 100 of FIG. 1. Hereinafter, a case where the joined substrate 100 is used will be described as an example.

In this example, a step of removing a part of the metal plate 20 and the metal plate 30 in the joined substrate 100 and forming a plurality of the first conductor portion 41 and a plurality of the second conductor portion 42 on the first main surface 10A and the second main surface 10B is performed. Each of the plurality of the first conductor portion 41 is provided independently for each section 18. That is, the first conductor portions 41 formed in the adjacent sections 18 are separated from each other. Each of the plurality of second conductor portions is also provided independently for each section 18. That is, the second conductor portions 42 formed in the adjacent sections 18 are separated from each other.

This step may be performed by, for example, photolithography. Specifically, a photosensitive resist is printed on the surface 20A of the joined substrate 100. Then, a resist pattern having a predetermined shape is formed using an exposure apparatus. A similar resist pattern may be formed on the surface 30A of the metal plate 30. The resist may be a negative type or a positive type. Unnecessary resist is removed by, for example, cleaning.

After the resist pattern is formed, an etching process is performed to remove portions of the metal plate 20 and the metal plate 30 that are not covered by the resist pattern. Accordingly, the first main surface 10A and the second main surface 10B of the ceramic plate 10 are exposed in this portion. Thereafter, the resist pattern is removed. This results in the circuit substrate 200 illustrated in FIGS. 6 and 7 including the dummy portion 215 and the conductor formation portion 216.

Since the circuit substrate 200 has the second identification mark 52 on the surface of each of the plurality of the first conductor portion 41, it is excellent in traceability. In addition, the traceability can be ensured even after the circuit substrate 200 is divided along the division lines L1 and L2.

Surface treatment of the surface 20A of the metal plate 20 in the joined substrate 100 may be performed before forming the resist pattern. Examples of the surface treatment include chemical polishing in which a part of the surface 20A is dissolved and removed using a chemical agent. By such chemical polishing, for example, it is possible to remove foreign matter such as carbon attached to the surface 20A when manufacturing the joined substrate 100. In addition, the surface roughness can be increased to improve adhesion of the resist. When such surface finishing is performed, if the first identification mark 51 is made of the recessed portion 51a, the reading accuracy of the second identification mark 52 in the circuit substrate 200 can be maintained at a sufficiently high level. The range of the recessed portion 51a depth may be as described above.

In some modifications, the first identification mark 51 in the joined substrate 100 may be eliminated by surface treatment. Thus, it is possible to obtain a circuit substrate in which no identification mark remains on the surface of the first conductor portion 41. Accordingly, it is possible to obtain a circuit substrate and an individual substrate with the first conductor portion 41 having a sufficiently smooth surface.

The surface of at least one of the first conductor portion 41 and the second conductor portion 42 of the circuit substrate 200 may be plated. The second identification mark 52 formed of the recessed portion 52a can be traced even after plating. In some modifications, a part of the surface of the first conductor portion 41 (for example, a part where the second identification mark 52 is provided) may be covered with a protection layer such as a solder resist, and a plating film may be formed only on the other part of the surface.

A method for manufacturing an individual substrate according to one embodiment includes: a step of performing at least an etching process on a joined substrate to form a plurality of first conductor portions on a first main surface so as to be independent for each section, and to form a plurality of second conductor portions on a second main surface so as to be independent for each section; and a step of dividing a circuit substrate including the plurality of first conductor portions and the plurality of second conductor portions along a division line to obtain an individual substrate including one of the plurality of sections, one of the plurality of first conductor portions, and one of the plurality of second conductor portions, in which one of the plurality of first conductor portions has a second identification mark on a surface thereof. The steps of forming the first conductor portions and the second conductor portions on the first main surface and the second main surface, respectively, may be similar to the steps in the method for manufacturing the circuit substrate 200 described above. Hereinafter, a case where the circuit substrate 200 is used will be described as an example.

The circuit substrate 200 is divided along the division lines L1 and L2. Thus, as illustrated in FIG. 8, the individual substrate 300 having the second identification mark 52 derived from the first identification mark 51 on the surface of the first conductor portion 41 is obtained. Such an individual substrate 300 can trace back information about the manufacturing conditions to the joined substrate 100 by reading the second identification mark 52. For example, lot numbers, manufacturing information, quality information, and the like of the metal plate 20, the joined substrate 100, and the circuit substrate 200, and the like that are used can be examined. This makes it possible to perform process management, quality management, and the like, so that the manufacturing method is excellent in traceability.

Although some embodiments of the present disclosure and modifications thereof have been described above, the present disclosure is not limited to the above-described embodiments and modifications thereof. For example, the shapes of the plurality of first conductor portions 41 provided in the plurality of the section 18 do not need to be the same as each other, and may be different for each section 18. The same applies to the plurality of second conductor portion 42. The shapes of the ceramic plate and the metal plate are not particularly limited. For example, in the joined substrate 100, four corners of the ceramic plate 10 protrudes outward from the corner portions of the metal plate 20 and the metal plate 30, but only some of the corner portion 11 may protrude from the corner portions of the pair of metal plates. The ceramic and the pair of metal plate may have the same shape.

The number of each identification mark is not particularly limited. For example, the first conductor portion in the individual substrate may have a plurality of second identification marks on the surface thereof. One of the plurality of second identification marks may be a backup, or the plurality of second identification marks may include different pieces of information. In addition, a conductor portion may be provided on the dummy portion 215, and the identification mark may be provided on the surface of the conductor portion. The identification mark may be used to ensure the traceability of the joined substrate and the circuit substrate.

The second identification mark 52 on the circuit substrate 200 is not limited to those derived from the first identification mark 51 on the joined substrate 100, and the second identification mark 52 may be formed on the surface of the first conductor portion 41 after the first conductor portion 41 is formed by etching. In this case, the second identification mark 52 may be provided by forming the recessed portion 52a using a carbon dioxide laser, a YAG laser, or the like as a laser source, for example.

### [Example]

The content of the present disclosure will be described in more detail with reference to examples, but the present disclosure is not limited to the following examples.

### [Formation of Two-Dimensional Code]

### (Example 1)

A first copper plate (thickness: 0.8 mm), a ceramic plate (silicon nitride plate, thickness: 0.32 mm) and a second copper plate were prepared. The first copper plate and the ceramic plate, and the ceramic plate and the second copper plate were respectively joined using a brazing material to obtain a joined substrate in which the first copper plate, the ceramic plate, and the second copper plate were laminated in this order. The surface of the first copper plate of this joined substrate was irradiated with laser beam to form a two-dimensional code (the first identification mark 51) formed of a plurality of laser holes (the recessed portions 51a) as illustrated in FIG. 3. A commercially available laser marker (manufactured by KEYENCE CORPORATION, trade name: MD-X1520) was used to form the two-dimensional code. The outline of the two-dimensional code was as follows. The laser beam irradiation conditions were as shown in Table 1.
Code type: DMX (ECC200)
Code size: 2.2 mm × 2.2 mm
Number of cells: 16 × 16

### (Examples 2 to 12)

A two-dimensional code (the first identification mark 51) was formed on the surface of the first copper plate by the same procedure as in Example 1 except that the irradiation conditions of the laser beam were as shown in Table 1.

### [Evaluation of Two-Dimensional code]

In each example, the depth of a laser hole (the recessed portion 51a) constituting the two-dimensional code formed on the surface of the first copper plate was measured. For the measurement, a 3D shape measuring machine (manufactured by KEYENCE CORPORATION, model: VR-3000) was used. The measurement results were as shown in "Depth of Laser Hole (Before Treatment)" in Table 1. A fixed type code reader (manufactured by KEYENCE CORPORATION, model: SR-2000) was used to evaluate whether the two-dimensional code was readable. As a result, the two-dimensional codes of all of the examples were readable.

### [Surface Treatment of Joined Substrate]

A surface treatment was performed on the first copper plate and the second copper plate in the joined substrate of each example on which the two-dimensional code was formed. Specifically, a surface treatment agent containing hydrogen peroxide and sulfuric acid was used to dissolve a part of the surface layer of each copper plate to increase the surface roughness of the surface of each copper plate. Thereafter, the depth of the laser hole constituting the two-dimensional code was measured. The measurement method is the same as the method described above in [Evaluation of Two-Dimensional Code]. The measurement results are shown in "Depth of Laser Hole (After Treatment)" in Table 1.

**[Table 1]**

| | Laser Power | Scanning Speed | Pulse Frequency | Number of Repetition of Printing | Depth of Laser Hole (Before Treatment) | Depth of Laser Hole (After Treatment) |
|---|---|---|---|---|---|---|
| | [W] | [mm/sec] | [kHz] | [times] | [µm] | [µm] |
| Example 1 | 20 | 1000 | 30 | 50 | 15 | 13 |
| Example 2 | 20 | 2000 | 30 | 50 | 10 | 8 |
| Example 3 | 20 | 500 | 30 | 50 | 23 | 20 |
| Example 4 | 25 | 1000 | 30 | 50 | 25 | 23 |
| Example 5 | 15 | 1000 | 30 | 50 | 8 | 6 |
| Example 6 | 20 | 1000 | 50 | 50 | 12 | 11 |
| Example 7 | 20 | 1000 | 10 | 50 | 15 | 14 |
| Example 8 | 20 | 1000 | 30 | 15 | 5 | 4 |
| Example 9 | 20 | 1000 | 30 | 90 | 27 | 25 |
| Example 10 | 20 | 1000 | 30 | 1 | 3 | 1 |
| Example 11 | 20 | 2000 | 30 | 2 | 3 | 1 |
| Example 12 | 20 | 1000 | 30 | 5 | 4 | 2 |

It was confirmed that the two-dimensional code remained even after the surface treatment was performed. The depth of the laser hole tends to decrease after the surface treatment is performed. Accordingly, by increasing the depth of the laser hole (the recessed portion 51a), it is possible to prevent the occurrence of a reading error and improve the reading accuracy. On the other hand, when the depth of the laser hole (the recessed portion 51a) on the surface of the first copper plate is reduced, it is possible to obtain the circuit substrate and the individual substrate including the first conductor portion having small unevenness on the surface.

### Industrial Applicability

According to the present disclosure, it is possible to provide a circuit substrate and a method for manufacturing the same that are excellent in traceability. Further, it is possible to provide a joined substrate excellent in traceability. Yet further, it is possible to provide an individual substrate and a method for manufacturing the same that are excellent in traceability.

### Reference Signs List

10: ceramic plate; 10A: first main surface; 10B: second main surface; 11: corner portion; 15: dummy region; 16: conductor formation region; 18: section; 18a: dividing plate (ceramic plate); 20, 30: metal plate; 20A, 30A: surface; 26, 36: chamfered portion; 27, 37: outer edge; 28, 38: protruding portion; 41: first conductor portion; 42: second conductor portion; 42A: first circuit portion; 42B: second circuit portion; 51: first identification mark; 52: second identification mark; 51a, 52a: recessed portion; 60: semiconductor device; 62, 63: brazing layer; 70: heat dissipation portion; 72: cooling portion; 100: joined substrate; 200: circuit substrate; 215: dummy portion; 216: conductor formation portion; 300: individual substrate; 400: power module.

## Claims

1. Ajoined substrate comprising:
a ceramic plate including a plurality of sections defined by a division line formed on at least one of a first main surface and a second main surface; and
a pair of metal plates joined to the ceramic plate to cover the first main surface and the second main surface, respectively,
wherein at least one of the pair of metal plates has a plurality of first identification marks on a surface thereof.

2. The joined substrate according to claim 1, wherein the ceramic plate includes a conductor formation region and a dummy region, and
wherein at least one of the pair of metal plates has the plurality of first identification marks on a surface of a portion covering the conductor formation region.

3. The joined substrate according to claim 1, wherein the plurality of first identification marks include a code formed of a laser hole, and the laser hole has a depth of 3 µm or more.

4. The joined substrate according to claim 1, wherein the pair of metal plates include a protruding portion protruding outward from the first main surface and the second main surface of the ceramic plate, and the plurality of first identification marks are provided on an inner side of the protruding portion, and
wherein a corner portion of the ceramic plate protrudes outward from the pair of metal plates.

5. A circuit substrate comprising:
a ceramic plate including a plurality of sections defined by a division line formed on at least one of a first main surface and a second main surface;
a plurality of first conductor portions provided independently for each section on the first main surface; and
a plurality of second conductor portions provided independently for each section on the second main surface,
wherein each of the plurality of first conductor portions has a second identification mark on a surface thereof.

6. A circuit substrate obtained by performing at least an etching process on the joined substrate according to any one of claims 1 to 4, the circuit substrate comprising:
a plurality of first conductor portions provided independently for each section on the first main surface; and
a plurality of second conductor portions provided independently for each section on the second main surface,
wherein each of the plurality of first conductor portions has a second identification mark derived from one of the plurality of first identification marks on a surface thereof.

7. The circuit substrate according to claim 5, wherein the second identification mark includes a code formed of a laser hole, and the laser hole has a depth of 1 µm or more.

8. An individual substrate obtained by dividing the circuit substrate according to claim 5 or 7 along the division line, the individual substrate comprising:
one of the plurality of sections;
one of the plurality of first conductor portions; and
one of the plurality of second conductor portions,
wherein one of the plurality of first conductor portions has the second identification mark on a surface thereof.

9. The individual substrate according to claim 8, wherein one of the first conductor portions constitutes a heat dissipation portion, and one of the second conductor portions constitutes an electric circuit.

10. A method for manufacturing a circuit substrate, the method comprising:
performing at least an etching process on the joined substrate according to any one of claims 1 to 4 to form a plurality of first conductor portions on the first main surface so as to be independent for each section, and to form a plurality of second conductor portions on the second main surface so as to be independent for each section,
wherein each of the plurality of first conductor portions has a second identification mark derived from one of the first identification marks on a surface thereof.

11. A method for manufacturing an individual substrate, the method comprising:
performing at least an etching process on the joined substrate according to any one of claims 1 to 4 to form a plurality of first conductor portions on the first main surface so as to be independent for each section, and to form a plurality of second conductor portions on the second main surface so as to be independent for each section; and
dividing a circuit substrate comprising the plurality of first conductor portions and the plurality of second conductor portions along the division line to obtain an individual substrate comprising one of the plurality of sections, one of the plurality of first conductor portions and one of the plurality of second conductor portions, wherein one of the plurality of first conductor portions has a second identification mark on a surface thereof, the second identification mark being derived from one of the first identification marks.
